# EUROPEAN PATENT APPLICATION

(11) **EP 4 585 446 A1**
(43) Date of publication of application: **16.07.2025**
(21) Application number: 24151209.4
(22) Date of filing: 10.01.2024
(51) Int. Cl.: B60L 1/08, B60L 50/61, B60L 58/12, B60L 58/16

(54) **LOW VOLTAGE VEHICLE BATTERY TEST USING CONTROLLABLE ELECTRICAL POWER GENERATION**

(71) Applicant: VOLVO TRUCK CORPORATION, 405 08 Göteborg (SE)
(72) Inventor: LUNDSTEDT, Björn, 443 39 Lerum (SE); RICHARDSSON, Johan, 413 26 Göteborg (SE); SMIDEBRANT, Tobias, 415 51 Göteborg (SE)
(74) Representative: Kransell & Wennborg KB

(57) **Abstract**

A computer system (100) comprising processing circuitry (106) configured to: control an output voltage setpoint of an electric power generating device (112) in a vehicle (104) from a first output voltage setpoint (V1) to a second output voltage setpoint (V2), the second output voltage setpoint (V2) is below an expected present voltage level (Vp) of an electrical energy storage device (102) connected to the electric power generating device (116) and higher than or equal to a presently required voltage level (Vr) for powering at least one electronic device (116) of the vehicle, determine, while the output voltage setpoint of the electric power generating device (112) remains below the expected present voltage level (Vp) of the electrical energy storage device (102), at least one electrical energy storage parameter (P), evaluate the at least one electrical energy storage parameter (P) in view of at least one predetermined criterion (K), and provide an output message (M) indicating the outcome of the evaluation.

## Description

### TECHNICAL FIELD

The disclosure relates generally to electrical energy storage devices in vehicles. In particular aspects, the disclosure relates to low voltage vehicle battery test using controllable electrical power generation. The disclosure can be applied to heavy-duty vehicles, such as trucks, buses, and construction equipment, among other vehicle types. The disclosure may further be applied to marine vessels and industrial stationary applications. Although the disclosure may be described with respect to a particular vehicle, the disclosure is not restricted to any particular vehicle.

### BACKGROUND

Testing of electrical energy storages in vehicles is performed to ensure that the electrical energy storages can supply electrical devices with electric power. Failure of the electrical energy storages may cause inconvenience or even potentially hazardous situations.

In traditional testing methods the electrical energy storage is connected to an external charger or other dedicated testing equipment. Frequent testing is therefore often not possible. It would be desirable enable a more available and testing method for electrical energy storage that reduces downtime of the vehicle.

### SUMMARY

According to a first aspect of the disclosure, there is provided a computer system comprising processing circuitry configured to: control an output voltage setpoint of an electric power generating device in a vehicle from a first output voltage setpoint to a second output voltage setpoint, the second output voltage setpoint is below an expected present voltage level of an electrical energy storage device connected to the electric power generating device and higher than or equal to a presently required voltage level for powering at least one electronic device of the vehicle, determine, while the output voltage setpoint of the electric power generating device remains below the expected present voltage level of an electrical energy storage device, at least one electrical energy storage parameter, evaluate the at least one electrical energy storage parameter in view of at least one predetermined criterion, and provide an output message indicating the outcome of the evaluation.

The first aspect of the disclosure may seek to provide a testing method that allows testing of an electrical energy storage in a vehicle during driving conditions. A technical benefit may include reduced downtime for the vehicle. A further technical benefit may include improved, i.e., more frequent, monitoring of the electrical energy storage status.

Optionally in some examples, including in at least one preferred example, the first output voltage setpoint may be higher than the second output voltage setpoint. In other words, the control of the electric power generating device is a drop in the voltage setpoint. A technical benefit may include that the drop in voltage setpoint produces a window that allows for voltage decay of the electrical energy storage during which the electrical energy storage can be tested. Meanwhile, the second output voltage setpoint of the electric power generating device provides a safe voltage level that ensures continued operation of the vehicle electrical devices even if the electrical energy storage voltage falls significantly.

Optionally in some examples, including in at least one preferred example, the processing circuitry may be further configured to: control the output voltage setpoint of the electric power generating device while the vehicle is moving. A technical benefit may include even further reduced downtime and improved, more frequent monitoring of the electrical energy storage device.

Optionally in some examples, including in at least one preferred example, the processing circuitry may be further configured to: detect that an engine of the vehicle is started, and in response, initiate the control of the electric power generating device output voltage setpoint. A technical benefit may include that a testing of the electrical energy storage device is initiated prior to travelling with the vehicle. Further, a trigger for evaluating the electrical energy storage device ensures frequent testing.

Optionally in some examples, including in at least one preferred example, the processing circuitry may be further configured to: at predetermined time interval, initiate the control of the output voltage setpoint of the electric power generating device, and the subsequent steps. A technical benefit may include that using predetermined time interval ensures frequent evaluation. Note that the evaluation, or testing, of the electrical energy storage device may be performed even when the vehicle is travelling.

Optionally in some examples, including in at least one preferred example, the processing circuitry may be further configured to: determine that a present electric current throughput of the electrical energy storage device exceeds a high current threshold, and in response, initiate the control of the output voltage setpoint of the electric power generating device, and the subsequent steps. A technical benefit may include that the test of the electrical energy storage is performed when it gives most value, that is, during high load situations.

Optionally in some examples, including in at least one preferred example, the electrical energy storage device has a voltage level in the range of 9V to 60V . This type of electrical energy storage device is herein denoted a low voltage electrical energy storage device or battery. For example, the electrical energy storage device may be a 12V, 24V, or a 48V electrical energy storage device.

Optionally in some examples, including in at least one preferred example, the electric power generating device is an alternator. Alternators of commonly induced in vehicle systems to generate electrical energy from mechanical motion in the vehicle engine.

Optionally in some examples, including in at least one preferred example, wherein evaluating the at least one electrical energy storage parameter in view of at least one predetermined criterion includes to evaluate a voltage output decay rate and a voltage level of the electrical energy storage device in view of predetermined decay rate and voltage level thresholds. A technical advantage is that a relatively straight forward and easily measured parameter is used for evaluating the electrical energy storage device.

There is further provided a vehicle comprising the computer system according to the first aspect.

According to a second aspect of the disclosure, there is provided a computer-implemented method, comprising: controlling, by processing circuitry of a computer system, a output voltage setpoint of an electric power generating device in a vehicle from a first output voltage setpoint to a second voltage setpoint, the second output voltage setpoint is below an expected present voltage level of an electrical energy storage device connected to the electric power generating device and higher than or equal to a presently required voltage level for powering at least one electronic device of the vehicle, determining, by the processing circuitry, at least one electrical energy storage parameter while the output voltage setpoint of the electric power generating device remains below the expected present voltage level of an electrical energy storage device, evaluating, by the processing circuitry, the at least one electrical energy storage parameter in view of at least one predetermined criterion, and providing, by the processing circuitry, an output message indicating the outcome of the evaluation.

The second aspect of the disclosure may seek to provide a testing method that allows testing of an electrical energy storage device in a vehicle during driving conditions. A technical benefit may include reduced downtime for the vehicle. A further technical benefit may include improved, i.e., more frequent, monitoring of the electrical energy storage status.

Optionally in some examples, including in at least one preferred example, the first output voltage setpoint may be higher than the second output voltage setpoint. In other words, the control of the electric power generating device is a drop in the voltage setpoint, i.e., in the intended voltage out from the alternator. A technical benefit may include that the drop in voltage setpoint produces a window that allows for voltage decay of the electrical energy storage device during which the electrical energy storage device can be evaluated as can be equally termed tested. Meanwhile, the second output voltage setpoint of the electric power generating device provides a safe voltage level that ensures continued operation of the vehicle electrical devices even if the electrical energy storage voltage falls significantly.

Optionally in some examples, including in at least one preferred example, the method may further comprise: controlling, by the processing circuitry, the output voltage setpoint of the electric power generating device while the vehicle is moving. A technical benefit may include even further reduced downtime and improved, more frequent monitoring of the electrical energy storage device.

Optionally in some examples, including in at least one preferred example, the method may comprise: detecting, by the processing circuitry, that the engine is started, and in response, initiate the control of the electric power generating device output voltage setpoint. A technical benefit may include that a testing of the electrical energy storage device is initiated prior to travelling with the vehicle. Further, a trigger for evaluating the electrical energy storage device ensures frequent testing.

Optionally in some examples, including in at least one preferred example, the method may comprise: at predetermined time interval, initiating, by the processing circuitry, the control of the voltage setpoint of the electric power generating device, and the subsequent steps. A technical benefit may include that using predetermined time interval ensures frequent evaluation. Note that the evaluation, or testing, of the electrical energy storage device may be performed even when the vehicle is travelling.

Optionally in some examples, including in at least one preferred example, the method may comprise: determining, by the processing circuitry, that a present electric current throughput of the electrical energy storage device exceeds a high current threshold, and in response, initiate the control of the output voltage setpoint of the electric power generating device and the subsequent steps. A technical benefit may include that the test of the electrical energy storage is performed when it gives most value, that is, during high load situations.

Optionally in some examples, including in at least one preferred example, the electrical energy storage device being an electrical energy storage device having a voltage in the range of 9V to 60V . This type of electrical energy storage device is herein denoted a low voltage electrical energy storage device or battery. For example, the electrical energy storage device may be a 12V, 24V, or a 48V electrical energy storage device.

Optionally in some examples, including in at least one preferred example, the electric power generating device is an alternator. Alternators of commonly induced in vehicle systems to generate electrical energy from mechanical motion in the vehicle engine.

Optionally in some examples, including in at least one preferred example, wherein evaluating the at least one electrical energy storage parameter in view of at least one predetermined criterion includes evaluating a voltage output decay rate and voltage level of the electrical energy storage device in view of predetermined decay rate threshold and voltage level threshold. A technical advantage is that a relatively straight forward and easily measured parameter is used for evaluating the electrical energy storage device.

There is further provided a computer program product comprising program code for performing, when executed by the processing circuitry, the method of the second aspect.

A non-transitory computer-readable storage medium comprising instructions, which when executed by the processing circuitry, cause the processing circuitry to perform the method of the second aspect.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

**FIG. 1** is an exemplary system diagram of a computer system according to an example.
**FIG. 2A** is a graph of voltage versus time for an electrical energy storage device with voltage setpoints of an electric power generating device overlaid in the same graph according to an example.
**FIG. 2B** is a graph of voltage versus time for an electrical energy storage device with voltage setpoints of an electric power generating device overlaid in the same graph according to an example.
**FIG. 3** is a flow chart of an exemplary method to test an electrical energy storage device according to examples.
**FIG. 4** is a truck according to an example vehicle.
**FIG. 5** is another view of **FIG. 1****,** according to an example.
**FIG. 6** is a flow chart of an exemplary method to test an electrical energy storage device according to an example.
**FIG. 7** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

Electrical energy storage devices of vehicles need to be tested to ensure safe operation of the vehicle. The electrical energy storage devices typically at relatively low voltages support electrical devices of the vehicles that may be important for the operation of the vehicle. For example, the electrical devices may be used for electrical steering servo, lighting devices, control systems for brakes, or for powering devices of the driveline of the vehicle. Testing of the electrical energy storage may be perform during charging or during a workshop visit. Consequently, failure of the electrical energy storage device may occur before testing was possible. Therefore, it would be desirable to be able to evaluate the performance of electrical energy storage devices on-board vehicles more frequently, as is laid out in the herein disclosed examples.

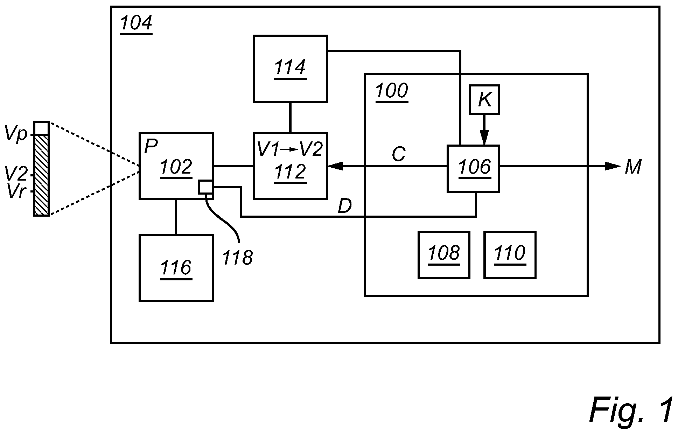

**FIG. 1** is an exemplary system diagram of a computer system 100 configured to evaluate or test an electrical energy storage device 102 of a vehicle 104 according to an example.

The computer system 100 comprising processing circuitry 106 having access to computer program product 108 and a non-transitory computer-readable medium 110.

The processing circuitry is configured to control an output voltage setpoint of an electric power generating device 112 in the vehicle 102. The electric power generating device 112 is connected to the electrical energy storage device 102 so that it can, when required, charge the electrical energy storage device 102. The electric power generating device 112 is connected to a source 114 from which it can receive energy that can be transferred to the electrical energy storage device 102 at a voltage determined by a voltage setpoint.

In some examples, the electric power generating device 112 is an alternator and the source 114 is an engine of the vehicle, for example an internal combustion engine e.g., running on diesel. As the engine operates, mechanical motion of the engine is transferred to an input side of the alternator 112 that converts the mechanical motion to electrical energy. Alternators are *per se* known in the technical field but are typically based on magnetic induction. Other types of engines are of course possible as the source 114, for example hydrogen combustion engines and fuel cell based engines, or electrical engines.

In other examples, the electric power generating device 112 is an electrical machine. It is further envisaged that the electric power generating device 112 is DC-DC converter connected to a source 114 being a high voltage battery such as a traction battery.

The electrical energy storage device 102 may comprise at least one electrical energy storage cell with a cell chemistry. In examples, the electrical energy storage device 102 is a lead acid battery and in other examples the electrical energy storage device 102 is a Li-ion battery.

The electrical energy storage device 102 is connectable to electronic devices 116 of the vehicle 104 that it powers by its stored electrical energy.

The processing circuitry 106 is configured to control a voltage setpoint of the electric power generating device 112 by transmitting control messages C to the electric power generating device 112. In this way, the processing circuitry 106 can cause the electric power generating device 112 to alter its voltage setting from a first output voltage setpoint, V1, to a second output voltage setpoint, V2.

The second output voltage setpoint, V2, is below an expected present voltage level, Vp, of the electrical energy storage device 102 connected to the electric power generating device 112 and higher than or equal to a presently required voltage level, Vr, for powering at least one electronic device 116 of the vehicle 104. This ensures that the at least one electronic device 116 of the vehicle 104 can continue its operation even if the electric energy storage device 102 turns out to not work as intentioned, that is, that it cannot provide the desired voltage.

The expected present voltage level, Vp, is the present voltage of the electrical energy storage device 102 and is affected by the voltage of the electric power generating device 112. The expected present voltage level, Vp, may for example be higher than the nominal voltage of the electrical energy storage device 102. For example, if the electric power generating device 112 presently provides a higher voltage than the nominal voltage of the electrical energy storage device 102, then the present voltage of the electrical energy storage device 102 is that of the electric power generating device 112, thus, higher than the nominal voltage of the electrical energy storage device 102. Preferably, the second voltage setpoint, V2, is below the nominal voltage of the electrical energy storage device 102. For example, the second voltage setpoint, V2 may be in the range of 10% to 95% of the nominal voltage, or in the range of 30% to 95% of the nominal voltage, or in the range of 50% to 90% of the nominal voltage. In examples, the second voltage setpoint, V2 is about 50%, or about 60%, or about 70%, or about 80%, or about 90% of the nominal voltage of the electric energy storage device 102.

The processing circuitry 102 is configured to determine, while the output voltage setpoint of the electric power generating device 112 remains below the expected present voltage level, Vp, of the electrical energy storage device 102, at least one electrical energy storage parameter P. The processing circuitry 106 is configured to receive measurement data D from sensors 118 that are configured to measure at least voltage across poles of the electric energy storage device 102. Other measurements data that may be acquired is temperature of the electric energy storage device 102 and electric current output from the electric energy storage device 102.

The processing circuitry 102 is configured to evaluate the at least one electrical energy storage parameter P in view of at least one predetermined criterion, K, and provide an output message M indicating the outcome of the evaluation.

The output message M may include a fault code or any other indication of a dysfunctional electrical energy storage device 102, or a code or indication that the status of the electrical energy storage device 102 is ok and that the electrical energy storage device 102 operates as expected. The output message M may further comprise information about functions with high power requirements that may be switched off. Additionally, or alternatively, the output message M may include digital trouble codes (DTCs).

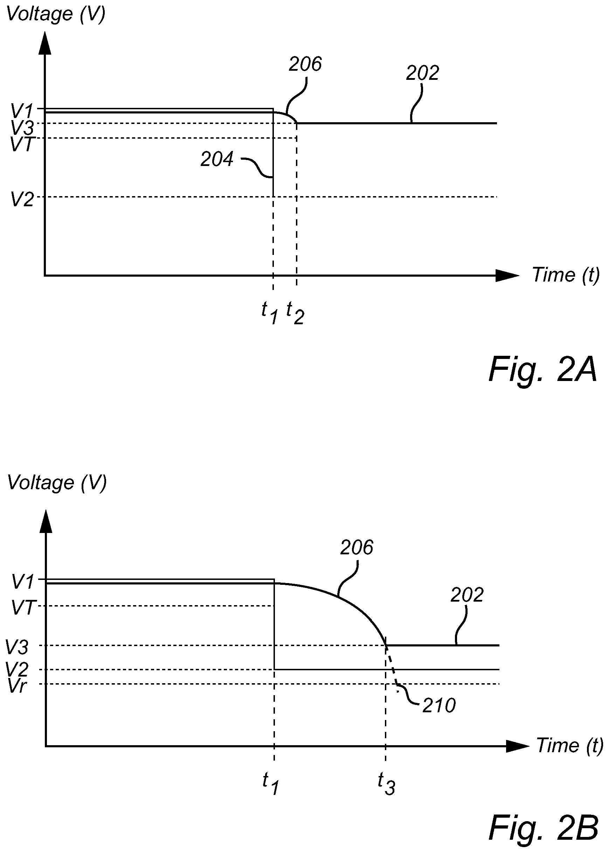

**FIG. 2A** is a graph of voltage versus time for the electrical energy storage device 102 with the voltage setpoint of the electric power generating device 112 overlaid in the same graph. The thick line 202 is the voltage of the electrical energy storage device 102 and the thin line 204 is the voltage setpoint of the electric power generating device 112. A small artificial gap is intentionally made between the lines 202 and 204 at the level V1 to provide clarity in the drawing. In practice, the lines overlap at level V1, that is, when the electric power generating device 112 is set to voltage setpoint V1, the output of the electrical energy storage device 102 will also be at the corresponding voltage V1.

The first voltage setpoint is V1 and the second voltage setpoint of the electric power generating device 112 is V2. In this example, the first output voltage setpoint V1 is higher than the second output voltage setpoint V2. In other words, the electric power generating device 112 is controlled so that a drop in voltage setpoint occurs.

At time t1, the voltage setpoint of the electric power generating device 112 changes from the relatively higher V1 to the relatively lower V2. As this drop occurs, a window appears that allows the voltage of the electrical energy storage device 102 to drop according to a decay 206. In this particular case, the voltage drops from level V1 to level V3 during a time duration from time t1 to time t2. The drop is here not significant which indicates a healthy electrical energy storage device 102. For example, the drop stops at level V3 which is higher than a voltage level thresholds VT which may be one possible one predetermined criterion that one electrical energy storage parameter P may be evaluated in view of. Stated otherwise, to evaluate the at least one electrical energy storage parameter in view of at least one predetermined criterion may include to evaluate a level of voltage of after the decay in view of a voltage level threshold VT.

Furthermore, one other or additional possible electrical energy storage parameter P is the voltage output decay rate that may be evaluated in view of a predetermined voltage decay rate. In other words, the decay rate during the decay 206, or the shape of the decay 206 may be evaluated to determine the health of the electrical energy storage device 102.

**FIG. 2B** is another graph of voltage versus time for the electrical energy storage device 102 with the voltage setpoint of the electric power generating device 112 overlaid in the same graph with same annotations as in FIG. 2A. In this case, the voltage level V3 is below the voltage level threshold VT which would indicate a faulty electrical energy storage device 102 that can no longer provide the desired voltage. Again, the decay 206 from time t1 to time t3 may be evaluated in view of a predetermined voltage decay rate threshold.

If the electrical energy storage device 102 is even worse, the decay 206 may not stop at time t3. Instead, the voltage decay may continue along the dashed curve 210 to hypothetically reach below the level V2 set by the second voltage setpoint V2 of the electric power generating device 112. However, since the second voltage setpoint V2 of the electric power generating device 112 exceeds the presently required voltage level, Vr, for powering at least one electronic device 116 of the vehicle 104, the electronic devices 116 still receives electrical energy that ensures their operation despite the electrical energy storage device 102 being unfit to do so. The required electric energy is then provided from the electric power generating device 112. In other words, even if the electrical energy storage device 102 turns out to be unable to provide the required electrical energy, it can still be tested online during operation of the vehicle since the electric power generating device 112 guarantees the required electrical energy.

Accordingly, the processing circuitry may be further configured to control the output voltage setpoint of the electric power generating device 112 while the vehicle 104 is moving. Thus, the testing sequence described above may be initiated even when the vehicle is moving, either with the engine off for example during coasting, or with the engine on. However, the herein disclosed testing sequence is equally applicable to a standing still vehicle.

It is further envisaged that the processing circuitry 106 is configured to initiate the testing sequence at predetermined time interval. That is the control of the output voltage setpoint of the electric power generating device 112 is initiated at predetermined intervals, followed by the subsequent steps of determining and evaluating the electrical energy storage parameter P, and providing the output message M. Predetermined interval may be for example every 5 minutes, every 10 minutes, every 30 minutes, or preferably every 15 minutes.

The duration of the test sequence described with reference to figs. 2A-B may range from 1-10 seconds or from 10 seconds to about 10 minutes depending on the circumstances. In preferred embodiments, the voltage setpoint of the power generating device is altered relatively quickly so that the test can be performed in less than a minute, or even in the range 1-10 seconds.

With reference again to **FIG. 1****,** when the source 114 is an engine, the processing circuitry 106 may, in one example, be configured to detect that the engine 114 is started. That is, the processing circuitry 106 is connected to the engine or control systems thereof to receive data a message that indicate engine start. In response to detecting an engine start, the processing circuitry 106 the control of the output voltage setpoint of the electric power generating device 112 followed by the subsequent steps of determining and evaluating the electrical energy storage parameter P, and providing the output message M.

In another example, the processing circuitry 106 is configured to determine that a present electric current throughput of the electrical energy storage device 102 exceeds a high current threshold. The electric current through the electrical energy storage device 102 may be sensed using sensors 118 that measure electric current or derive the electric current from voltage measurements. In response to detecting a high electric current output of the electrical energy storage device 102, the processing circuitry 106 initiate the control of the output voltage setpoint of the electric power generating device, followed by the subsequent steps of determining and evaluating the electrical energy storage parameter P, and providing the output message M.

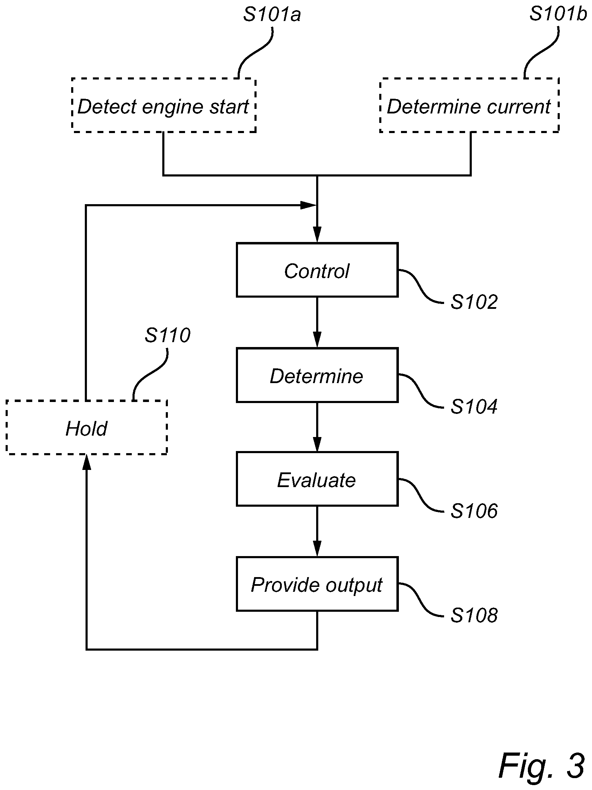

**FIG. 3** is a flow-chart of a computer-implemented method to test an electrical energy storage device according to an example.

The method comprises controlling S102, by processing circuitry 106 of a computer system 100, an output voltage setpoint of an electric power generating device 112 in a vehicle 104 from a first output voltage setpoint V1 to a second voltage setpoint V2.

The second output voltage setpoint is below an expected present voltage level Vp of an electrical energy storage device 102 connected to the electric power generating device 112 and higher than or equal to a presently required voltage level Vr for powering at least one electronic device 116 of the vehicle.

Step S104 includes determining, by the processing circuitry 106, at least one electrical energy storage parameter P while the output voltage setpoint of the electric power generating device 112 remains below the expected present voltage level Vp of the electrical energy storage device 102.

Step S106 includes evaluating, by the processing circuitry 106, the at least one electrical energy storage parameter P in view of at least one predetermined criterion K.

Step S108 includes providing, by the processing circuitry 106, an output message M indicating the outcome of the evaluation.

This controlling step S102 may be performed while the vehicle is moving whereby the subsequent steps S104-S108 follow, also while the vehicle is moving.

Alternatively, the step S102 is preceded by optional step S101a comprising detecting, by the processing circuitry 106, that the engine 114 is started, and in response, initiate the control of the electric power generating device output voltage setpoint in step S102, whereby the subsequent steps S104-S108 follow.

As a further alternative, the step S102 is preceded by optional step S101b comprising determining, by the processing circuitry 106, that a present electric current throughput of the electrical energy storage device 102 exceeds a high current threshold, and in response, initiate the control of the output voltage setpoint of the electric power generating device in step S102 whereby the subsequent steps S104-S108 follow.

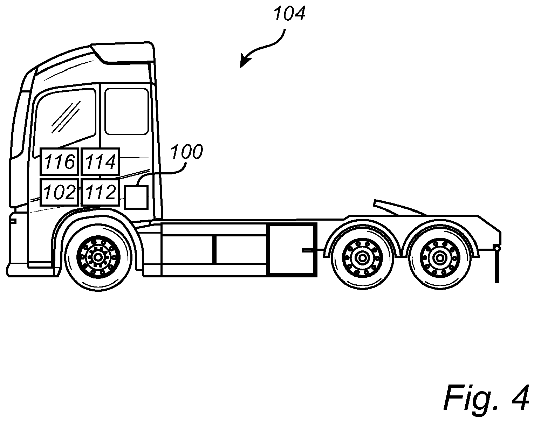

As a further optional alternative, shown in the flow-chart of FIG. 4, the processing circuitry 106 may initiate step S102 to control of the voltage setpoint of the electric power generating device at predetermined time interval. Thus, once the output is provided in step S108, the sequence holds in optional step S 110 for a predetermined duration TD, and once the predetermined duration TD has lapsed, step S102 is again initiated.

The optional steps S101a, S101b, and S110 may be combined or may stand alone one by one.

**FIG. 4** is an example vehicle 104 according to examples of the present disclosure. The vehicle 104 is here shown as a heavy-duty truck but other types of vehicles are also applicable. The vehicle 104 comprises the computer system 100, the electric power generating device 112, the electrical energy storage device 102, the power source 114, and electronic device 116. The vehicle 104 may be comprise a hybrid-, or fully electric driveline, or the vehicle may be propelled by an internal combustion engine such as a diesel engine.

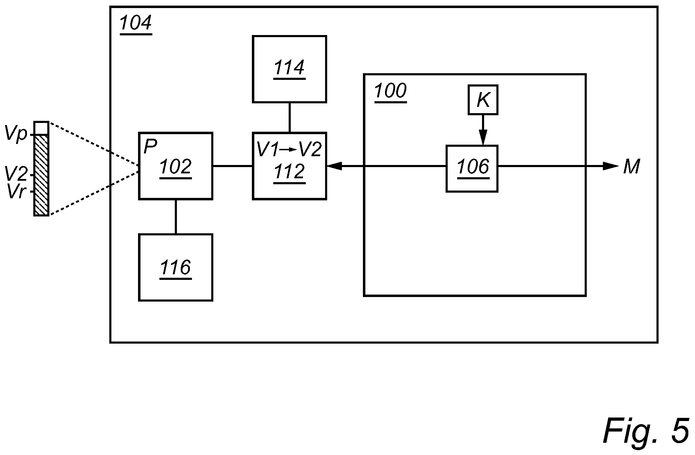

**FIG. 5** is another view of **FIG. 1****,** according to an example. FIG 5 is a diagram of a computer system 100 comprising processing circuitry 106 configured to: control an output voltage setpoint of an electric power generating device 112 in a vehicle 104 from a first output voltage setpoint V1 to a second output voltage setpoint V2, the second output voltage setpoint V2 is below an expected present voltage level Vp of an electrical energy storage device 102 connected to the electric power generating device 112 and higher than or equal to a presently required voltage level Vr for powering at least one electronic device 116 of the vehicle, determine, while the output voltage setpoint of the electric power generating device 112 remains below the expected present voltage level Vp of the electrical energy storage device 102, at least one electrical energy storage parameter P, evaluate the at least one electrical energy storage parameter P in view of at least one predetermined criterion K, and provide an output message M indicating the outcome of the evaluation.

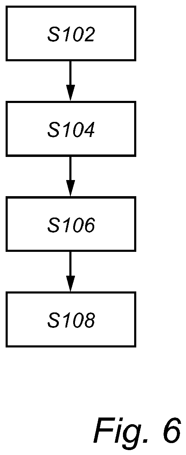

**FIG. 6** is a flow chart of a computer-implemented method to test an electrical energy storage device according to an example. The method comprises controlling in step S102, by processing circuitry 106 of a computer system 100, an output voltage setpoint of an electric power generating device 112 in a vehicle 104 from a first output voltage setpoint V1 to a second voltage setpoint V2, the second output voltage setpoint is below an expected present voltage level Vp of an electrical energy storage device 102 connected to the electric power generating device 112 and higher than or equal to a presently required voltage level Vr for powering at least one electronic device 116 of the vehicle, determining in step S104, by the processing circuitry 106, at least one electrical energy storage parameter P while the output voltage setpoint of the electric power generating device 112 remains below the expected present voltage level Vp of the electrical energy storage device 102, evaluating in step S106, by the processing circuitry 106, the at least one electrical energy storage parameter P in view of at least one predetermined criterion K, and providing in step S108, by the processing circuitry 106, an output message M indicating the outcome of the evaluation.

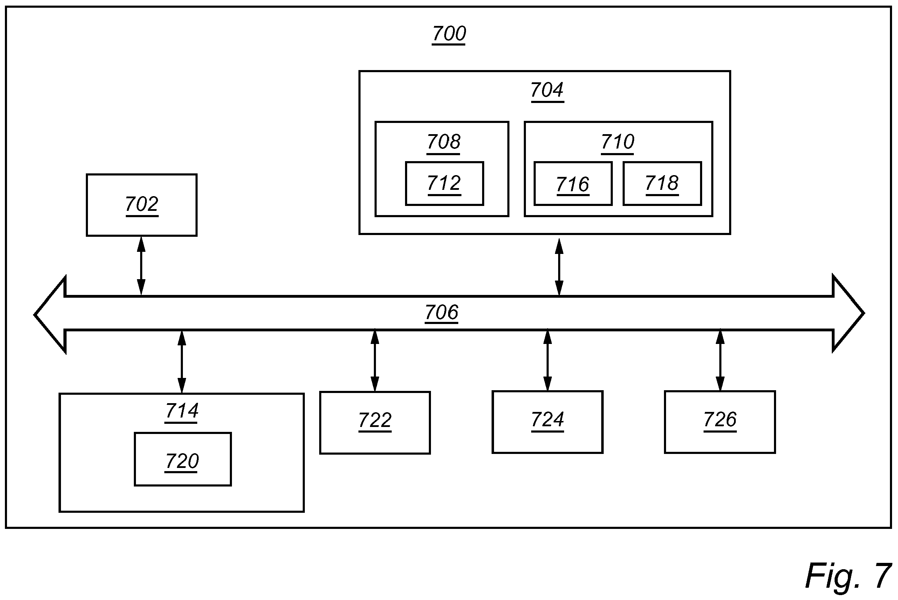

**FIG. 7** is a schematic diagram of a computer system **700** for implementing examples disclosed herein. The computer system **700** is adapted to execute instructions from a computer-readable medium to perform these and/or any of the functions or processing described herein. The computer system **700** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **700** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **700** may comprise at least one computing device or electronic device capable of including firmware, hardware, and/or executing software instructions to implement the functionality described herein. The computer system **700** may include processing circuitry **702** (e.g., processing circuitry including one or more processor devices or control units), a memory **704,** and a system bus **706.** The computer system **700** may include at least one computing device having the processing circuitry **702.** The system bus **706** provides an interface for system components including, but not limited to, the memory **704** and the processing circuitry **702.** The processing circuitry **702** may include any number of hardware components for conducting data or signal processing or for executing computer code stored in memory **704.** The processing circuitry **702** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **702** may further include computer executable code that controls operation of the programmable device.

The system bus **706** may be any of several types of bus structures that may further interconnect to a memory bus (with or without a memory controller), a peripheral bus, and/or a local bus using any of a variety of bus architectures. The memory **704** may be one or more devices for storing data and/or computer code for completing or facilitating methods described herein. The memory **704** may include database components, object code components, script components, or other types of information structure for supporting the various activities herein. Any distributed or local memory device may be utilized with the systems and methods of this description. The memory **704** may be communicably connected to the processing circuitry **702** (e.g., via a circuit or any other wired, wireless, or network connection) and may include computer code for executing one or more processes described herein. The memory **704** may include non-volatile memory **708** (e.g., read-only memory (ROM), erasable programmable read-only memory (EPROM), electrically erasable programmable read-only memory (EEPROM), etc.), and volatile memory **710** (e.g., random-access memory (RAM)), or any other medium which can be used to carry or store desired program code in the form of machine-executable instructions or data structures and which can be accessed by a computer or other machine with processing circuitry **702.** A basic input/output system (BIOS) **712** may be stored in the non-volatile memory **708** and can include the basic routines that help to transfer information between elements within the computer system **700.**

The computer system **700** may further include or be coupled to a non-transitory computer-readable storage medium such as the storage device **714,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **714** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **714** and/or in the volatile memory **710,** which may include an operating system **716** and/or one or more program modules **718.** All or a portion of the examples disclosed herein may be implemented as a computer program **720** stored on a transitory or non-transitory computer-usable or computer-readable storage medium (e.g., single medium or multiple media), such as the storage device **714,** which includes complex programming instructions (e.g., complex computer-readable program code) to cause the processing circuitry **702** to carry out actions described herein. Thus, the computer-readable program code of the computer program **720** can comprise software instructions for implementing the functionality of the examples described herein when executed by the processing circuitry **702.** In some examples, the storage device **714** may be a computer program product (e.g., readable storage medium) storing the computer program **720** thereon, where at least a portion of a computer program **720** may be loadable (e.g., into a processor) for implementing the functionality of the examples described herein when executed by the processing circuitry **702.** The processing circuitry **702** may serve as a controller or control system for the computer system **700** that is to implement the functionality described herein.

The computer system **700** may include an input device interface **722** configured to receive input and selections to be communicated to the computer system **700** when executing instructions, such as from a keyboard, mouse, touch-sensitive surface, etc. Such input devices may be connected to the processing circuitry **702** through the input device interface **722** coupled to the system bus **706** but can be connected through other interfaces, such as a parallel port, an Institute of Electrical and Electronic Engineers (IEEE) 1394 serial port, a Universal Serial Bus (USB) port, an IR interface, and the like. The computer system **700** may include an output device interface **724** configured to forward output, such as to a display, a video display unit (e.g., a liquid crystal display (LCD) or a cathode ray tube (CRT)). The computer system **700** may include a communications interface **726** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1: A computer system comprising processing circuitry configured to: control an output voltage setpoint of an electric power generating device in a vehicle from a first output voltage setpoint to a second output voltage setpoint, the second output voltage setpoint is below an expected present voltage level of an electrical energy storage device connected to the electric power generating device and higher than or equal to a presently required voltage level for powering at least one electronic device of the vehicle, determine, while the output voltage setpoint of the electric power generating device remains below the expected present voltage level of the electrical energy storage device, at least one electrical energy storage parameter, evaluate the at least one electrical energy storage parameter in view of at least one predetermined criterion, and provide an output message indicating the outcome of the evaluation.

Example 2: The computer system of example 1, wherein the first output voltage setpoint is higher than the second output voltage setpoint.

Example 3: The computer system of any of examples 1-2, wherein the processing circuitry is further configured to: control the output voltage setpoint of the electric power generating device while the vehicle is moving.

Example 4: The computer system of any of examples 1-3, wherein the processing circuitry is further configured to: detect that an engine of the vehicle is started, and in response, initiate the control of the electric power generating device output voltage setpoint.

Example 5: The computer system of any of examples 1-4, wherein the processing circuitry is further configured to: at predetermined time interval, initiate the control of the output voltage setpoint of the electric power generating device, and the subsequent steps.

Example 6: The computer system of any of examples 1-5, wherein the processing circuitry is further configured to: determine that a present electric current throughput of the electrical energy storage device exceeds a high current threshold, and in response, initiate the control of the output voltage setpoint of the electric power generating device, and the subsequent steps.

Example 7: The computer system of any of examples 1-6, the electrical energy storage device being an electrical energy storage device having a voltage in the range of 9V to 60V.

Example 8: The computer system of any of examples 1-7, wherein the electric power generating device is an alternator.

Example 9: The computer system of any of examples 1-8, wherein evaluate the at least one electrical energy storage parameter in view of at least one predetermined criterion includes to evaluate a voltage output decay rate and a voltage level of the electrical energy storage device in view of a predetermined decay rate threshold and a voltage level threshold.

Example 10: A vehicle comprising the computer system of any of examples 1-9.

Example 11: A computer-implemented method, comprising: controlling, by processing circuitry of a computer system, a output voltage setpoint of an electric power generating device in a vehicle from a first output voltage setpoint to a second voltage setpoint, the second output voltage setpoint is below an expected present voltage level of an electrical energy storage device connected to the electric power generating device and higher than or equal to a presently required voltage level for powering at least one electronic device of the vehicle, determining, by the processing circuitry, at least one electrical energy storage parameter while the output voltage setpoint of the electric power generating device remains below the expected present voltage level of the electrical energy storage device, evaluating, by the processing circuitry, the at least one electrical energy storage parameter in view of at least one predetermined criterion, and providing, by the processing circuitry, an output message indicating the outcome of the evaluation.

Example 12: The method of example 11, wherein the first output voltage setpoint is higher than the second voltage setpoint.

Example 13: The method of any of examples 11-12, comprising: controlling, by the processing circuitry, the output voltage setpoint of the electric power generating device while the vehicle is moving.

Example 14: The method of any of examples 11-13, comprising: detecting, by the processing circuitry, that the engine is started, and in response, initiate the control of the electric power generating device output voltage setpoint.

Example 15: The method of any of examples 11-14, comprising: at predetermined time interval, initiating, by the processing circuitry, the control of the voltage setpoint of the electric power generating device, and the subsequent steps.

Example 16: The method of any of examples 11-15, comprising: determining, by the processing circuitry, that a present electric current throughput of the electrical energy storage device exceeds a high current threshold, and in response, initiate the control of the output voltage setpoint of the electric power generating device and the subsequent steps.

Example 17: The method of any of examples 11-16, the electrical energy storage device being an electrical energy storage device having a voltage in the range of 9V to 60V.

Example 18: The method of any of examples 11-17, wherein the electric power generating device is an alternator coupled to an engine of the vehicle.

Example 19: The method of any of examples 11-18, wherein evaluating the at least one electrical energy storage parameter in view of at least one predetermined criterion includes evaluating a voltage output decay rate and a voltage level of the electrical energy storage device in view of a predetermined decay rate threshold and voltage level threshold.

Example 20: A computer program product comprising program code for performing, when executed by the processing circuitry, the method of any of examples 11-19.

Example 21: A non-transitory computer-readable storage medium comprising instructions, which when executed by the processing circuitry, cause the processing circuitry to perform the method of any of examples 11-19.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (100) comprising processing circuitry (106) configured to:
control an output voltage setpoint of an electric power generating device (112) in a vehicle (104) from a first output voltage setpoint (V1) to a second output voltage setpoint (V2), the second output voltage setpoint (V2) is below an expected present voltage level (Vp) of an electrical energy storage device (102) connected to the electric power generating device (116) and higher than or equal to a presently required voltage level (Vr) for powering at least one electronic device (116) of the vehicle,
determine, while the output voltage setpoint of the electric power generating device (112) remains below the expected present voltage level (Vp) of the electrical energy storage device (102), at least one electrical energy storage parameter (P),
evaluate the at least one electrical energy storage parameter (P) in view of at least one predetermined criterion (K), and
provide an output message (M) indicating the outcome of the evaluation.

2. The computer system of claim 1, wherein the first output voltage setpoint is higher than the second output voltage setpoint.

3. The computer system of any of claims 1-2, wherein the processing circuitry is further configured to:
control the output voltage setpoint of the electric power generating device while the vehicle is moving.

4. The computer system of any of claims 1-3, wherein the processing circuitry is further configured to:
detect that an engine of the vehicle is started, and in response, initiate the control of the electric power generating device output voltage setpoint.

5. The computer system of any of claims 1-4, wherein the processing circuitry is further configured to:
at predetermined time interval, initiate the control of the output voltage setpoint of the electric power generating device, and the subsequent steps.

6. The computer system of any of claims 1-5, wherein the processing circuitry is further configured to:
determine that a present electric current throughput of the electrical energy storage device exceeds a high current threshold, and in response, initiate the control of the output voltage setpoint of the electric power generating device, and the subsequent steps.

7. The computer system of any of claims 1-6, the electrical energy storage device being an electrical energy storage device having a voltage in the range of 9V to 60V .

8. The computer system of any of claims 1-7, wherein the electric power generating device is an alternator.

9. The computer system of any of claims 1-8, wherein evaluate the at least one electrical energy storage parameter in view of at least one predetermined criterion includes to evaluate a voltage output decay rate and a voltage level of the electrical energy storage device in view of a predetermined decay rate threshold and a voltage level threshold.

10. A vehicle comprising the computer system of any of claims 1-9.

11. A computer-implemented method, comprising:
controlling (S102), by processing circuitry (106) of a computer system (100), a output voltage setpoint of an electric power generating device (112) in a vehicle (104) from a first output voltage setpoint (V1) to a second voltage setpoint (V2), the second output voltage setpoint is below an expected present voltage level (Vp) of an electrical energy storage device (102) connected to the electric power generating device (112) and higher than or equal to a presently required voltage level (Vr) for powering at least one electronic device (116) of the vehicle,
determining (S104), by the processing circuitry (106), at least one electrical energy storage parameter (P) while the output voltage setpoint of the electric power generating device (112) remains below the expected present voltage level (Vp) of the electrical energy storage device (102),
evaluating (S106), by the processing circuitry (106), the at least one electrical energy storage parameter (P) in view of at least one predetermined criterion (K), and
providing (S108), by the processing circuitry (106), an output message (M) indicating the outcome of the evaluation.

12. The method of claim 11, wherein the first output voltage setpoint is higher than the second voltage setpoint.

13. The method of any of claims 11-12, comprising:
controlling, by the processing circuitry, the output voltage setpoint of the electric power generating device while the vehicle is moving.

14. A computer program product (108) comprising program code for performing, when executed by the processing circuitry, the method of any of claims 11-13.

15. A non-transitory computer-readable storage medium (110) comprising instructions, which when executed by the processing circuitry, cause the processing circuitry to perform the method of any of claims 11-13.
